# EUROPÄISCHE PATENTSCHRIFT

(11) **EP 1 228 541 B1**
(45) Veröffentlichungstag und Bekanntmachung des Hinweises auf die Patenterteilung: **17.08.2005**
(21) Anmeldenummer: 00982998.7
(22) Anmeldetag: 12.10.2000
(51) Int. Cl.: H01L 41/00

(54) **VERFAHREN ZUR HERSTELLUNG EINES PIEZOELEKTRISCHEN WANDLERS**
METHOD FOR PRODUCING A PIEZOELECTRIC TRANSDUCER
PROCEDE DE FABRICATION D'UN TRANSDUCTEUR PIEZO-ELECTRIQUE

(30) Priorität: 10.11.1999 DE 19954020
(43) Veröffentlichungstag der Anmeldung: 07.08.2002
(73) Patentinhaber: Fraunhofer-Gesellschaft zur Förderung der angewandten Forschung e.V., 80686 München (DE)
(72) Erfinder: SEFFNER, Lutz, 01108 Dresden (DE); SCHÖNECKER, Andreas, 01705 Freital (DE); GEBHARDT, Sylvia, 01277 Dresden (DE)
(74) Vertreter: Gagel, Roland, Dr.
(86) Internationale Anmeldenummer: PCT/DE2000/003609
(87) Internationale Veröffentlichungsnummer: WO 2001/035468

(56) Entgegenhaltungen:
- US-A- 4 726 099
- US-A- 5 660 877
- US-A- 5 869 189

## Beschreibung

Die Erfindung betrifft ein Verfahren zur Herstellung eines piezoelektrischen Wandlers, der aus piezoelektrischen Fasern in einer Polymermatrix besteht, auf der Elektroden zur Ansteuerung der Fasern aufgebracht sind.

Piezoelektrische Materialien sind für viele technische Anwendungsgebiete von Bedeutung. Es handelt sich hierbei um Stoffe, die unter Einwirkung einer mechanischen Beanspruchung elektrische Ladungen erzeugen oder sich unter Einwirkung eines elektrischen Feldes verformen. Ersteres ist unter den Begriff direkter piezoelektrischer Effekt bekannt, letzteres wird als indirekter piezoelektrischer Effekt bezeichnet.
Eine bestimmte Gruppe piezoelektrischer Materialien stellen die Piezokeramiken dar. Zur Herstellung von Piezokeramiken muss der piezoelektrische Effekt gezielt herbeigeführt werden, indem die Keramik nach deren Sinterung in einem starken elektrischen Feld gepolt wird. Dabei werden bestimmte Bereiche der Keramik, die Domänen, entlang der elektrischen Feldlinien ausgerichtet, sodass die Keramik in dieser Richtung polarisiert wird. Nach dem Abschalten des elektrischen Feldes verbleibt ein Teil dieser Polarisation als remanente Polarisation in der Keramik. Durch diesen Polungsvorgang wird somit aus einem isotropen ein anisotroper Werkstoff mit piezoelektrischen Eigenschaften. Bei Anlegen eines elektrischen Feldes beispielsweise in Polungsrichtung an die Keramik dehnt sich diese in Feldrichtung aus (d₃₃-Effekt), während sie orthogonal dazu kontrahiert (d₃₁-Effekt). Die Art der Deformation hängt somit von der Richtung des angelegten Feldes relativ zur Polungsrichtung der Keramik ab. Der 3-1 Effekt ist etwa nur 1/3 so groß wie der 3-3 Effekt, d.h. die Deformation in Feldrichtung. Bei Einsatz piezoelektrischer Keramiken als Aktoren in der Technik wird daher in der Regel angestrebt, den 3-3 Effekt zu nutzen.
Selbstverständlich lassen sich piezoelektrische Keramiken durch Nutzung des direkten piezoelektrischen Effektes auch als Sensoren einsetzen. Hierbei erzeugt eine Deformation der Keramik eine elektrische Ladung, deren Größe unter anderem auch davon abhängt, wie die Deformation relativ zur Richtung der remanenten Polarisation der Keramik erfolgt.

Der derzeit technisch am häufigsten eingesetzte piezoelektrische Werkstoff ist Bleititanatzirkonat (PZT). Diese Keramik wird in der Technik seit langer Zeit in vielfältiger Weise als Resonator-, Aktor- oder Sensorwerkstoff verwendet.
Für viele Anwendungen sind feinskalige Bauteile wie Folien, Stäbchen oder Fasern vorteilhaft. Bei diesen ergibt sich jedoch das Problem der geringen mechanischen Festigkeit der in dieser Form bereitzustellenden piezoelektrischen Keramiken. Dies betrifft sowohl deren Handhabung bei der Herstellung komplexer Strukturen aus diesen Keramiken als auch die begrenzte Möglichkeit der Kraftübertragung durch den piezoelektrische Effekt in ein Bauteil.

Zur Überwindung dieser Problematik werden daher häufig Komposite, bestehend aus einer organischen Polymermatrix mit darin eingelagerter PZT-Keramik verwendet. Die Polymermatrix hat dabei einerseits die Aufgabe, den dünnwandigen keramischen Elementen eine genügend große mechanische Stabilität zu verleihen, und andererseits die von der Piezokeramik erzeugten Deformationen, beispielsweise bei der Dämpfung von Schwingungen, in die Struktur zu übertragen.

So ist aus der US 5,687,462 ein Aktor in Kompositbauweise bekannt, bei dem gesinterte piezokeramische Folien in einer organischen Matrix integriert sind. Die dadurch entstehenden robusten Bauelemente können in schwingenden Systemen sowohl sensorisch wie auch aktorisch eingesetzt werden. Die Matrix verleiht dabei der brüchigen PZT-Keramik mechanische Festigkeit und dient auch der Kraftübertragung in eine größere Struktur. Bei diesen Elementen wird das elektrische Feld üblicherweise in Dickenrichtung an die PZT-Folie angelegt, sodass der 3-1 Effekt genutzt wird. Es ist auch möglich, durch Aufbringung von Interdigitalelektroden auf die PZT-Folie den 3-3 Effekt aktorisch zu nutzen. Hierbei treten in Keramikfolien jedoch große Feldgradienten an den Elektrodenecken auf, die zu großen Spannungen in der Keramik und zum Bruch der monolithischen Piezokeramik führen können.

In letzter Zeit wurden daher neben den PZT-Folien auch Komposite eingesetzt, bei denen aktive piezoelektrische Fasern in eine Polymermatrix eingebettet sind. Diese Systeme lassen sich sowohl unter Ausnutzung des 3-1 Effektes als auch - mit Interdigitalelektroden - unter Ausnutzung des 3-3 Effektes betreiben.
Diese Faserkomposite besitzen gegenüber Kompositen mit monolithischer PZT-Folie mehrere Vorteile. So wird zum einen durch die Anisotropie der Fasern hauptsächlich eine Dehnung in Faserlängsrichtung angeregt, zum anderen können die Fasern in großer Ausdehnung in die gesamte Struktur integriert werden. Eine Anpassung an eine räumlich geformte Struktur ist mit den Fasern leichter zu realisieren als mit einer monolithischen PZT-Folie.

Ein großes Problem bei der Herstellung von Kompositen aus piezoelektrischen Fasern ist jedoch die große Bruchanfälligkeit dieser Fasern, die spezielle Vorrichtungen für deren Handhabung erfordert. So ist beispielsweise in der US 5,869,189 ein Verfahren zur Herstellung von Faserkompositen beschrieben, aus dem diese Problematik deutlich wird. Bei dem dort vorgeschlagenen Verfahren werden mehrere lang gestreckte piezoelektrische Fasern parallel und in definiertem Abstand zueinander in eine Form eingelegt. Zur Gewährleistung des korrekten Abstandes und der Parallelität der Fasern kann am Boden dieser Form eine kammartige Struktur vorgesehen sein. Anschließend wird ein flüssiges Polymermaterial in die Form eingebracht und mit den Fasern ausgehärtet. Die dadurch entstehende Polymermatrix weist im Wesentlichen die Dicke der Monolage der Fasern auf. Anschließend wird die Oberfläche dieser Polymermatrix leicht abgeschliffen. Dies dient zum einen der Aufrauhung der Oberfläche, zum anderen dem Freilegen von Bereichen der Fasern. Schließlich wird metallisches Silber als Elektrodenschicht auf die Oberfläche der Matrix abgeschieden. Durch die vorher durchgeführte Aufrauhung wird die Haftung dieser Elektrodenschicht verbessert, durch das Freilegen einzelner Bereiche der Fasern kann ein direkter elektrischer Kontakt zu den Fasern hergestellt werden.

Ein großes Problem bei der Herstellung dieses Faserkomposits besteht jedoch im Einbringen der langen piezoelektrischen Fasern in paralleler Anordnung in die dafür vorgesehene Form. Hierbei besteht die große Gefahr, dass viele Fasern zerbrechen. Weiterhin ist die erforderliche parallele Ausrichtung mit einem erheblichen Herstellungsaufwand verbunden. Auch die hierfür erforderliche Bereitstellung sehr gerader Fasern ist problematisch, da sich Fasern bei der Herstellung oft leicht krümmen und dann nicht mehr parallel ausrichten lassen. Dies ist insbesondere bei sehr dünnen Fasern mit Durchmessern < 50 µm der Fall.

Ein weiteres Verfahren zur Herstellung von Faserkompositen ist aus der DE 198 29 216 A bekannt. Hierbei werden die Fasern über ihren Umfang von den Elektroden direkt kontaktiert und zumindest teilweise umschlossen. Dies wird erreicht, in dem die Fasern in leitfähigem Klebstoff fixiert und anschließend vergossen werden. Dabei besteht jedoch das Problem, dass die Fasern nicht zu dicht beieinander liegen dürfen, da sonst der Klebstoff vor dem Aushärten in Folge der Kapillarkräfte zwischen die Fasern gezogen wird. Dadurch wird die elektrische Durchschlagfestigkeit stark herabgesetzt und die Wahrscheinlichkeit für elektrische Durchschläge bei der Polung der Fasern oder bei aktorischen Anwendungen ist sehr hoch. Außerdem bleiben auch bei diesem Verfahren die Schwierigkeiten bei der Handhabung der extrem brüchigen piezoelektrischen Keramikfasern bestehen.

Die Aufgabe der vorliegenden Erfindung besteht darin, ein Verfahren zur Herstellung eines piezoelektrischen Wandlers anzugeben, das die obigen Nachteile nicht aufweist, einfach durchführbar ist und den Einsatz von Fasern oder Faserbündeln jeder Qualität ermöglicht. Das Verfahren soll weiterhin auch die Herstellung großflächiger nicht ebener Bauteile mit direkt integrierten piezoelektrischen Fasern erlauben und Wandler mit hoher Spannungsfestigkeit gewährleisten.

Die Aufgabe wird mit dem Verfahren nach Anspruch 1 gelöst. Vorteilhafte Ausgestaltungen des Verfahrens sind Gegenstand der Unteransprüche.

Bei dem erfindungsgemäßen Verfahren werden die piezoelektrischen Fasern nach ihrer Herstellung entweder als Einzelfasern, als Schüttung kurzer Faserstücke, als Faserbündel, d.h. einer beliebigen Gruppierung von zumindest zwei Fasern, oder in einer entsprechenden Kombination mit einer Polymermasse umhüllt. Dies kann durch Einbringen der Fasern oder Faserstücke in eine flüssige Polymermasse oder durch Aufbringen eines flüssigen Polymers auf die Fasern oder Faserstücke erfolgen. Die piezoelektrischen Fasern oder Faserstücke werden dabei derart angeordnet, dass sich eine Verteilung der Längsachsen der Fasern oder Faserstücke bzw. - bei nicht geradlinig verlaufenden Fasern - eine Verteilung der Längsachsen von Abschnitten der Fasern oder Faserstücke um eine Vorzugsrichtung ergibt. Dies ist ohne aufwendiges genaues Ausrichten der einzelnen Komponenten möglich.
Das Umhüllen der Fasern oder Faserstücke erfolgt vorzugsweise in einer dafür vorgesehenen Form, die die äußere Geometrie des Komposits vorgibt. Die Fasern oder Faserstücke werden im Polymer untereinander verdichtet, d.h. räumlich näher aneinander gebracht, und das Polymer wird ausgehärtet. Anschließend wird der dadurch entstandene Komposit derart bearbeitet, dass entlang der Vorzugsrichtung, d.h. in einer Ebene parallel zur Vorzugsrichtung, Bereiche der Fasern oder Faserstücke freigelegt werden. Schließlich wird der elektrische Kontakt direkt auf zumindest einen Teil der freigelegten Bereiche aufgebracht. Die einzelnen freigelegten Bereiche sollten hierbei so groß sein, dass zumindest zwei gegensinnige Elektroden auf einem Bereich Platz finden.

Bei diesem Verfahren kann eine Faseranordnung verwendet werden, bei der die Längsachsen der Fasern statistisch um eine Vorzugsrichtung verteilt angeordnet sind. Vorzugsweise ergibt sich bei der Mehrzahl der Fasern eine maximale Abweichung ihrer Längsachse von 30° von dieser Vorzugsrichtung. In einer Ausführungsform, bei der im Wesentlichen gerade Fasern eingesetzt werden, weicht ein Anteil von zumindest 50% der Fasern in der Polymermatrix über ihre Länge um mindestens einen Faserdurchmesser von der Vorzugsrichtung ab. Es ist auch möglich, gekrümmte Fasern zu verwenden, die um mindestens einen Faserdurchmesser von einer geradlinigen Form abweichen und daher nicht parallel ausgerichtet werden können.
Wird bei dem erfindungsgemäßen Komposit, das die Faser umhüllende Polymer in bestimmten Bereichen in einer Ebene parallel zur Vorzugsrichtung entfernt, so kann aufgrund der Verteilung der Längsachsen immer ein bestimmter Anteil der insgesamt vorhandenen Fasern kontaktiert werden. Der hierdurch kontaktierbare Anteil umfasst sowohl den zahlenmäßigen Anteil der Fasern insgesamt als auch die Länge der kontaktierten Abschnitte einer Faser in Längsrichtung. Eine Faser muss hierbei also nicht auf ihre Gesamtlänge kontaktiert sein, sondern es ist auch möglich, viele Fasern auf kurzen Abschnitten ihrer Gesamtlänge zu kontaktieren. Die Kontaktierung erfolgt vorzugsweise mittels einer Interdigitalelektrode, die als elektrischer Kontakt auf die nach der Bearbeitung vorliegende Oberfläche des Komposits aufgebracht wird.

Beim erfindungsgemäßen Verfahren ist keine aufwendige parallele Ausrichtung der einzelnen Fasern in definiertem Abstand zueinander erforderlich. Das Verfahren erfordert auch keine langen und geraden Einzelfasern. Vielmehr wird durch die Verteilung der Fasern oder Faserstücke, die nicht alle exakt parallel zueinander liegen, eine einfache, statistische Kontaktierung erreicht. Wird hierbei beispielsweise die Oberfläche des Komposits abgeschliffen, so treten an unterschiedlichen Stellen die Bereiche unterschiedlicher Fasern an die Oberfläche und können dort kontaktiert werden.
Die Herstellung eines derartigen piezoelektrischen Wandlers ist daher mit wesentlich weniger Aufwand verbunden, als dies bei den bekannten Wandlern des Standes der Technik der Fall ist. Die geometrische Qualität der Fasern spielt hierbei keine Rolle.

Die elektrische Kontaktierung kann beispielsweise durch beidseitiges Aufbringen einer elektrisch leitfähigen Schicht erfolgen, oder durch Aufbringen einer Interdigitalstruktur auf eine oder beide Oberflächen.
Weiterhin ist es mit dem erfindungsgemäßen Verfahren möglich, einen piezoelektrischen Wandler auch in einer nichtplanen Form, beispielsweise angepasst an eine gekrümmte Oberfläche, herzustellen. Hierfür muss lediglich die äußere Form der Polymermatrix vor deren Aushärten in die gewünschte Form gebracht werden.

Die Bearbeitung des Komposits zur Freilegung von Bereichen der Fasern kann mit unterschiedlichen Techniken erfolgen. Beispiele hierfür sind Schleifen, Laserbearbeitung, Sägen, Sandstrahlen, nasschemisches Ätzen oder Ionenstrahltechniken.

Eine besonders vorteilhafte Ausgestaltung des Verfahrens besteht darin, einen Komposit mit den piezoelektrischen Fasern oder Faserstücken gemäß dem erfindungsgemäßen Verfahren herzustellen, der die vielfache Dicke des späteren Wandlers aufweist. Hierbei liegt die Vorzugsrichtung der Fasern oder Faserstücke senkrecht zur Dickenrichtung des Komposits. Die Bearbeitung des Komposits erfolgt in dieser bevorzugten Ausführungsform durch Auftrennen in Ebenen entlang der Faser-Vorzugsrichtung. Dieses Auftrennen kann beispielsweise durch Zersägen des Komposits erfolgen. Das Auftrennen erfolgt hierbei in einzelne Platten oder Scheiben, die die Dicke der zu erzeugenden piezoelektrischen Wandler aufweisen.
Durch dieses Zersägen liegen an der Oberfläche jeder der dadurch erzeugten Scheiben Bereiche der Fasern frei und können durch Aufbringen elektrischer Kontakte kontaktiert werden. Das Verfahren lässt sich sehr kostengünstig und einfach durchführen, da mit wenigen Schritten mehrere Wandler hergestellt werden.

Das erfindungsgemäße Verfahren wird nachfolgend anhand zweier Ausführungsbeispiele in Verbindung mit den Zeichnungen nochmals erläutert. Hierbei zeigen:
- Figur 1:: ein Beispiel für einen Block aus harz- oder polymer-infiltrierten Fasern mit einer Verteilung der Längsachsen der Fasern um eine Vorzugsrichtung;
- Figur 2:: den Block aus Figur 1 mit angedeuteter Schnittfläche zum Freilegen von Faserbereichen; und
- Figur 3:: die resultierende Oberfläche nach dem Schnitt und dem Aufbringen von Interdigitalelektroden.

Beim ersten Beispiel wird eine Form bereit gestellt, die eine Abmessung von 6 cm x 3 cm aufweist. Diese Form wird mit einem Polymer, das als Matrix verwendet werden soll, gefüllt. Als Polymer kann hierbei beispielsweise ein Epoxidharz verwendet werden. In das in der Form vorliegende flüssige Polymer werden 2,5 g eines Bündels piezoelektrischer Fasern, die eine Länge von etwa 5 cm haben, eingelegt und so verdichtet, dass eine Schicht von etwa 0,5 mm Dicke entsteht. Die einzelnen Fasern haben hierbei einen mittleren Faserdurchmesser von 20 bis 30 µm. Anschließend wird das Polymer mit den Fasern ausgehärtet. Nach dem Aushärten wird die Form entfernt, sodass eine flache Platte von 6 x 3 x 0,05 cm³ erhalten wird. Diese Platte wird anschließend auf den beiden gegenüberliegenden Seiten abgeschliffen. Auf eine dieser Seiten wird aus leitfähigem Klebstoff eine Interdigitalelektrode aus 50 Fingerpaaren mit einem Fingerabstand von 1 mm aufgebracht und nachfolgend mit einer dünnen Schicht Epoxidharz versiegelt.
Die zweite Seite kann in gleicher Weise mit einer Interdigitalelektrode versehen werden, die deckungsgleich mit der gegenüberliegenden Elektrode aufgebracht wird.
Der hierdurch entstehende piezoelektrische Wandler in Form eines Komposits kann sowohl als Biegeaktor, als Dehnungswandler als auch für sensorische Zwecke verwendet werden. Er kann auch in eine Struktur eingebaut und beispielsweise zum Zwecke der Schwingungsdämpfung eingesetzt werden.

Bei einem zweiten Beispiel werden 61 g piezoelektrischer Fasern in eine Form mit flüssigem Epoxidharz eingebracht und zu einem Block der Abmessungen 2 x 2 x 5 cm³ verdichtet. Nach dem Aushärten wird dieser Block in Faserlängsrichtung zu einzelnen Platten von 2 x 5 cm und einer Dicke von 0,2 mm gesägt. Danach wird beidseitig eine Interdigitalelektrode aus 50 Fingerpaaren mit einem Fingerabstand von 1 mm spiegelbildlich auf jede der Platten aufgebracht und nachfolgend mit einer dünnen Schicht Epoxidharz versiegelt.

Auf diese Weise wird ein Dehnungswandler hergestellt, der als versteifendes Element in eine Struktur integriert werden kann.

Hierbei handelt es sich um eine besonders vorteilhafte Ausführungsform des Verfahrens, weil die Herstellung des Wandlers und das Freilegen der Oberfläche in einem technologischen Schritt auf sehr einfache und kostengünstige Weise ausgeführt werden kann.

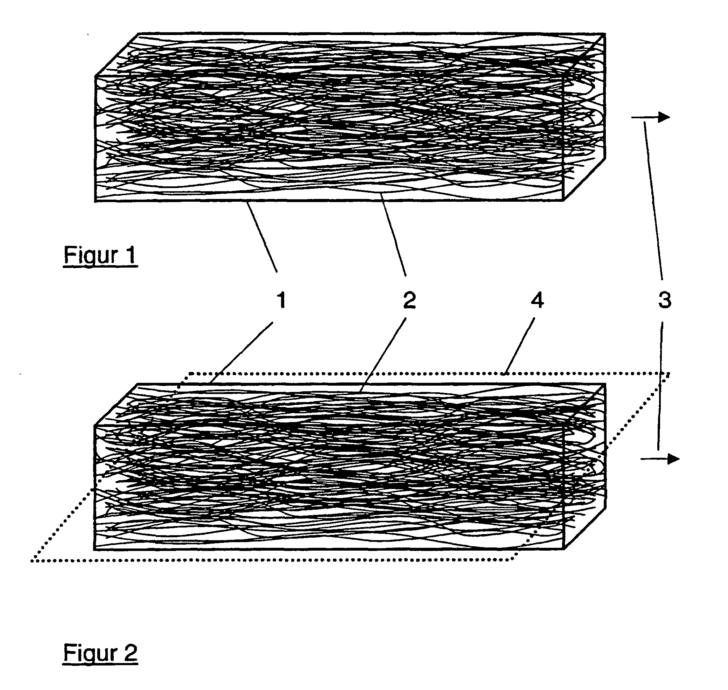

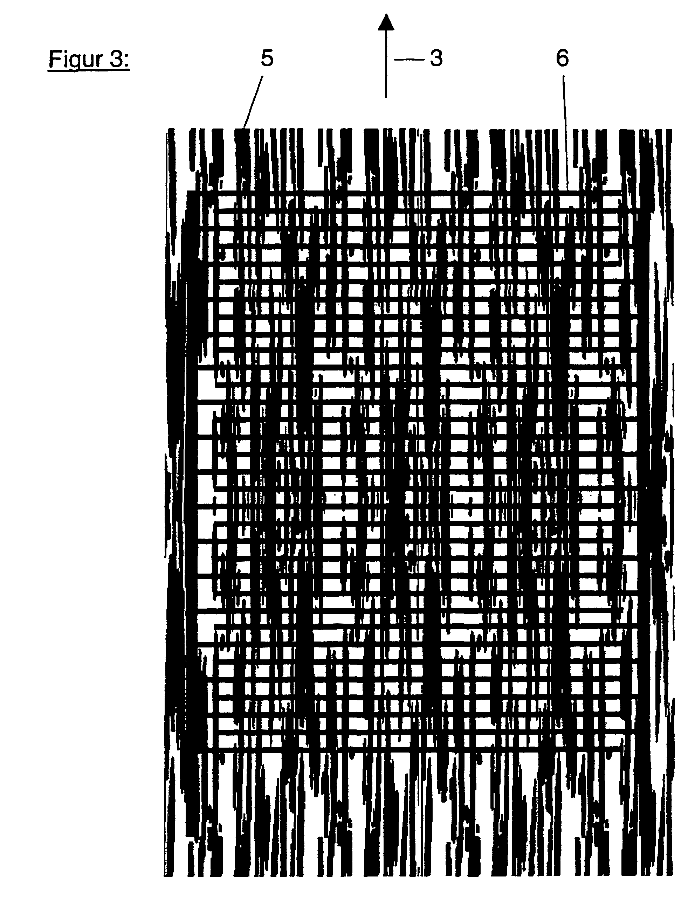

Figur 1 zeigt hierzu beispielhaft einen durch Verdichten und Aushärten hergestellten Block 1 aus harz- oder polymer-infiltrierten Fasern 2, deren Längsachsen um eine Vorzugsrichtung 3 verteilt sind. In diesem Beispiel ist auch sehr gut die nicht geradlinige Form der Fasern 2 zu erkennen, die die spätere Kontaktierung noch fördert.
In Figur 2 ist eine Schnittfläche 4 angedeutet, entlang der der Block 1 zersägt wird, um Bereiche der Fasern 2 entlang der Vorzugsrichtung 3 freizulegen.
Die aus dem Schnitt entlang der Schnittfläche 4 resultierende Oberfläche ist in Figur 3 dargestellt. In dieser Figur sind deutlich die durch den Schnitt entlang der Vorzugsrichtung 3 freigelegten Bereiche 5 der Fasern 2 ersichtlich. Auf die Oberfläche mit den freigelegten Faserbereichen 5 wird zur Kontaktierung der Fasern eine Interdigitalelektrode 6 aufgebracht, deren Finger senkrecht zur Vorzugsrichtung 3 verlaufen (vgl. Fig.3). Hierdurch wird auf einfache und kostengünstige Weise ein piezoelektrischer Wandler realisiert.

## Patentansprüche

1. Verfahren zur Herstellung eines piezoelektrischen Wandlers mit folgenden Schritten:
- Umhüllen von piezoelektrischen Fasern (2) oder Faserstücken mit einer flüssigen Polymermasse
- Aushärten der Polymermasse mit den Fasern (2) oder Faserstücken zu einem Komposit;
- Bearbeiten des Komposits, so dass Bereiche (5) der Fasern (2) oder Faserstücke entlang einer Vorzugsrichtung (3) freigelegt werden; und
- Aufbringen elektrischer Kontakte (6) zur Ansteuerung des Wandlers auf zumindest einen Teil der freigelegten Bereiche (5);
**dadurch gekennzeichnet,**
**dass** das Umhüllen der piezoelektrischen Fasern (2) oder Faserstücke mit einer flüssigen Polymermasse derart erfolgt, dass sich in der Polymermasse keine parallele Ausrichtung sondern eine Verteilung von Längsachsen zumindest von Abschnitten der Fasern (2) oder Faserstücke um die Vorzugsrichtung (3) ergibt, wobei die Fasern (2) oder Faserstücke vor dem Aushärten untereinander verdichtet werden und das Bearbeiten des Komposits durch Auftrennen in Ebenen entlang der Vorzugsrichtung (3) erfolgt.

2. Verfahren nach Anspruch 1,
**dadurch gekennzeichnet,**
**dass** das Auftrennen durch Zersägen des Komposits parallel zur Vorzugsrichtung (3) erfolgt.

3. Verfahren nach einem der Ansprüche 1 oder 2,
**dadurch gekennzeichnet,**
**dass** das Auftrennen mit einem Laserstrahl erfolgt.

4. Verfahren nach einem der Ansprüche 1 bis 3,
**dadurch gekennzeichnet,**
**dass** die elektrischen Kontakte (6) in Form einer oder mehrerer Interdigitalelektroden aufgebracht werden.

5. Verfahren nach einem der Ansprüche 1 bis 4,
**dadurch gekennzeichnet,**
**dass** das Umhüllen durch Einbringen der Fasern (2) oder Faserstücke als Bündel oder lose Schüttung in eine Form und Übergießen mit der flüssigen Polymermasse erfolgt.

6. Verfahren nach einem der Ansprüche 1 bis 5,
**dadurch gekennzeichnet,**
**dass** das Komposit plattenförmig hergestellt wird.

7. Verfahren nach einem der Ansprüche 1 bis 6, bei dem im Wesentlichen gerade Fasern (2) oder Faserstücke derart mit der flüssigen Polymermasse umhüllt werden, dass zumindest 50% der Fasern (2) oder Faserstücke in der Polymermasse über ihre Länge um mindestens einen Faserdurchmesser von der Vorzugsrichtung (3) abweichen.

8. Verfahren nach einem der Ansprüche 1 bis 6,
**dadurch gekennzeichnet,**
**dass** Fasern (2) oder Faserstücke eingesetzt werden, von denen zumindest die Hälfte einen gekrümmten Verlauf aufweist, der um mindestens einen Faserdurchmesser von einer geradlinigen Form abweicht.

## Claims

1. Method of manufacturing a piezoelectric transducer, comprising the following steps:
- jacketing piezoelectric fibres (2) or fibre segments with a liquid polymer substance;
- curing the polymer substance with the fibres (2) or fibre segments so as to form a composite structure;
- processing the composite structure so as to expose areas (5) of said fibres (2) or fibre segments along a preferential direction (3); and applying electrical contacts (6) for controlling the transducer on at least one part of said exposed areas (5);
**characterised in**
**that** the step of jacketing said piezoelectric fibres (2) or fibre segments with a liquid polymer substance is carried out in such a way that a distribution of longitudinal axes at least of sections of said fibres (2) or fibre segments about said preferential direction (3) occurs, rather than a parallel orientation, with said fibres (2) or fibre segments being compressed among each other prior to curing and with said processing operation being carried out by separation in planes along said preferential direction (3).

2. Method according to Claim 1,
**characterised in**
**that** said operation of separation is carried out by sawing the composite structure in parallel with said preferential direction (3).

3. Method according to Claim 1 or 2,
**characterised in**
**that** said operation of separation is carried out by means of a laser beam.

4. Method according to Claim 1 or 2,
**characterised in**
**that** said electrical contacts (6) are applied in the form of one or several inter-digital electrode(s).

5. Method according to any of the Claims 1 to 4,
**characterised in**
**that** said jacketing operation is carried out by placing said fibres (2) or fibre segments as a bundle or in loose bulk into a mould and by pouring said liquid polymer substance over them.

6. Method according to any of the Claims 1 to 5,
**characterised in**
**that** said composite structure is manufactured in a plate-shaped form.

7. Method according to any of the Claims 1 to 6,
wherein substantially straight fibres (2) or fibre segments are jacketed with said liquid polymer substance in such a way that at least 50 % of said fibres (2) or fibre segments in said polymer substance vary, along their length, by at least one fibre diameter from said preferential direction (3).

8. Method according to any of the Claims 1 to 6,
**characterised in**
**that** fibres (2) or fibre segments are placed whereof at least one half presents a curved extension that varies from a straight-lined form by at least one fibre diameter.

## Revendications

1. Procédé à fabriquer un convertisseur piézoélectrique, comprenant les étapes suivantes :
- envelopper des fibres piézoélectriques (2) ou des tronçons de fibres piézoélectriques d'une substance polymérique liquide ;
- durcir la substance polymérique, ensemble avec lesdites fibres (2) ou tronçons de fibres, afin de former un composite ;
- traiter ledit composite d'une telle manière, que des zones (5) desdits fibres (2) ou desdits tronçons de fibres soient exposés le long d'une direction préférentielle (3) ; et
- déposer des contacts électriques (6) pour la commande du convertisseur sur au moins une partie desdites zones exposées (5),
**caractérisé en ce**
**que** l'enveloppage desdites fibres piézoélectriques (2) ou desdits tronçons de fibres d'une substance polymérique liquide se fait d'une telle manière, que dans la substance polymérique, une orientation en parallèle ne soit pas atteinte, mais une distribution des axes longitudinaux au moins des tronçons de fibres (2) ou segments de fibres autour de ladite direction préférentielle (3), à une agglomération desdites fibres (2) ou tronçons de fibres, l'un relativement à l'autre, avant le durcissement et à un traitement du composite se faisant par séparation dans des plans le long de ladite direction préférentielle (3).

2. Procédé selon la revendication 1,
**caractérisé en ce**
**que** ladite séparation se fait par sciage du composite en morceaux en parallèle à ladite direction préférentielle (3).

3. Procédé selon une quelconque des revendications 1 ou 2,
**caractérisé en ce**
**que** la séparation se fait moyennant un faisceau laser.

4. Procédé selon une quelconque des revendications 1 à 3,
**caractérisé en ce**
**que** lesdits contact électriques (6) sont déposés sous forme d'une ou plusieurs électrodes interdigitales.

5. Procédé selon une quelconque des revendications 1 à 4,
**caractérisé en ce**
**que** l'enveloppage se fait par la pose desdites fibres (2) ou desdits tronçons de fibres sous forme d'un faisceau ou en vrac dans une moule et par versement de ladite substance polymérique liquide.

6. Procédé selon une quelconque des revendications 1 à 5,
**caractérisé en ce**
**que** ledit composite est fabrique en plaques.

7. Procédé selon une quelconque des revendications 1 à 6,
dans lequel des fibres (2) ou tronçons de fibres essentiellement droits sont enveloppés par ladite substance polymérique liquide d'une telle façon, qu'au moins 50% des fibres (2) ou tronçons de fibres dans ladite substance polymérique varient de ladite direction préférentielle (3) par au moins un diamètre de fibre sur toute leur longueur.

8. Procédé selon une quelconque des revendications 1 à 6,
**caractérisé en ce**
**que** des fibres (2) ou tronçons de fibres sont utilisés, dont au moins la moitié présente une allure courbée qui varie d'une forme rectiligne par au moins un diamètre de fibre.
